(19) Europäisches Patentamt
European Patent Office
Office européen des brevets

(11) **EP 3 609 147 B1**

(12) **FASCICULE DE BREVET EUROPEEN**

(45) Date de publication et mention de la délivrance du brevet:
**17.03.2021 Bulletin 2021/11**

(21) Numéro de dépôt: **19189882.4**

(22) Date de dépôt: **02.08.2019**

(51) Int Cl.:
*H04L 27/00* (2006.01)   *H04L 27/20* (2006.01)
*H04L 27/227* (2006.01)   *H03D 1/22* (2006.01)
*H03D 7/16* (2006.01)   *H03B 19/00* (2006.01)
*H03L 7/00* (2006.01)

(54) **SYSTÈME ANALOGIQUE DE RÉCUPÉRATION DE PORTEUSE POUR RÉCEPTEUR DE SIGNAL N-PSK**

**ANALOGES SYSTEM ZUR TRÄGERRÜCKGEWINNUNG FÜR N-PSK-SIGNALEMPFÄNGER**

**ANALOGUE SYSTEM FOR RECOVERING CARRIER FOR N-PSK SIGNAL RECEIVER**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.08.2018 FR 1857334**

(43) Date de publication de la demande:
**12.02.2020 Bulletin 2020/07**

(73) Titulaire: **Commissariat à l'énergie atomique et aux énergies alternatives 75015 Paris (FR)**

(72) Inventeurs:
• **SILIGARIS, Alexandre**
  **38054 GRENOBLE CEDEX 9 (FR)**
• **DEHOS, Cédric**
  **38054 GRENOBLE Cedex 9 (FR)**
• **GONZALEZ JIMENEZ, José-Luis**
  **38054 GRENOBLE Cedex 9 (FR)**
• **JANY, Clément**
  **38054 GRENOBLE CEDEX 9 (FR)**
• **MARTINEAU, Baudouin**
  **38054 GRENOBLE Cedex 9 (FR)**

(74) Mandataire: **Brevalex**
  **56, Boulevard de l'Embouchure**
  **B.P. 27519**
  **31075 Toulouse Cedex 2 (FR)**

(56) Documents cités:
**EP-A2- 2 434 647**

• SIMON M K ET AL: "CARRIER-TRACKING LOOPS EMPLOYING THE PHASE-LOCK PRINCIPLE", 1 janvier 1973 (1973-01-01), TELECOMMUNICATION SYSTEMS ENGINEERING, ENGLEWOOD CLIFFS, PRENTICE-HALL INC, US, PAGE(S) 26 - 84, XP000794149, * Sect. 2.5 * * figures 2-24, 2-31 *
• LINDSEY W C ED - LINDSEY W C: "SYSTEMS EMPLOYING THE PHASE-LOCK OR ENTRAINMENT PRINCIPLE", 1 janvier 1972 (1972-01-01), SYNCHRONIZATION SYSTEMS IN COMMUNICATION AND CONTROL, ENGLEWOOD CLIFFS, PRENTICE-HALL, US, PAGE(S) 65 - 129, XP000793780, * page 92 * * figures 3-7.1 *
• SHIH-JOU HUANG ET AL: "$W$ -Band BPSK and QPSK Transceivers With Costas-Loop Carrier Recovery in 65-nm CMOS Technology", IEEE JOURNAL OF SOLID-STATE CIRCUITS, IEEE SERVICE CENTER, PISCATAWAY, NJ, USA, vol. 46, no. 12, 1 décembre 2011 (2011-12-01), pages 3033-3046, XP011379209, ISSN: 0018-9200, DOI: 10.1109/JSSC.2011.2166469

EP 3 609 147 B1

**Description**

**DOMAINE TECHNIQUE**

La présente invention s'applique de manière générale au domaine des systèmes de télécommunication sans fil et plus particulièrement à ceux offrant un très haut débit (plusieurs dizaines de Gb/s) dans des conditions de courte portée ou de vue directe ou LOS (*Line Of Sight*).

**ÉTAT DE LA TECHNIQUE ANTÉRIEURE**

Les systèmes de télécommunication sans fil à très haut débit (plusieurs Gb/s) et courte portée peuvent être envisagés dans de nombreuses applications que ce soit le raccordement d'appareils mobiles (smartphones, tablettes, cameras, appareils photo etc.) à un dispositif fixe (PC, station d'accueil, télévision, serveur, etc.), les communications *peer to peer,* les réseaux locaux (LAN), la connectique industrielle ou robotique (notamment pour permettre une transmission de données entre organes en mouvement ou soumis à des vibrations) ou la connexion de faisceaux de câbles dans le domaine aéronautique ou spatial.

La plupart des architectures de transmission de données sans fil à haute efficacité énergétique (quelques pJ/bit) utilisent actuellement des modulations simples à faible efficacité spectrale (modulation OOK par exemple) et des récepteurs non cohérents, basés sur une simple détection de puissance ou d'enveloppe. Un exemple d'un tel système de communication est décrit dans l'article de H.J. Lee et al. intitulé « High-speed and low-power OOK CMOS transmitter and receiver for wireless chip-to-chip communication » publié dans Proc. of IMWS 2015. Ce système permet d'obtenir théoriquement un débit de 12 Gb/s entre un émetteur et un récepteur séparé de 1 cm en utilisant une modulation OOK (*On-Off Keying*) sur une porteuse à 80 GHz. La bande passante est de 15 GHz environ et la consommation du récepteur est de l'ordre de 3.8 pJ/bit.

En pratique, il est difficile d'obtenir des débits élevés avec ce type d'architecture, d'une part en raison de la limitation de la bande passante et d'autre part en raison de la faible efficacité spectrale de la modulation utilisée.

Il est toutefois possible d'utiliser des modulations d'ordre plus élevé (de phase, d'amplitude, de fréquence) pour atteindre des débits plus importants, mais il est alors nécessaire de recourir à un récepteur de type cohérent, c'est-à-dire à un récepteur dont la fréquence et la phase doivent être synchronisées avec celles de l'émetteur. La synchronisation du récepteur est réalisée par une boucle à verrouillage de phase ou PLL (*Phase Locked Loop*). Qui plus est, un circuit numérique de traitement du signal est généralement utilisé en réception pour effectuer une synchronisation fine nécessaire à la démodulation du signal. Lorsque le traitement est effectué à une très grande fréquence d'échantillonnage (pour des débits élevés), la consommation énergétique des convertisseurs analogiques/numériques et du circuit numérique devient alors importante. En outre, une boucle PLL consomme une puissance statique non négligeable. Ainsi les circuits de traitement utilisés pour la démodulation cohérente de signaux, par exemple au standard 802.11ad (WiGiG) à 60GHz, consomment-ils de 0.5 à 3W pour des débits de 1.9 à 3.8 Gb/s, consommation qui s'avère bien trop élevée pour la plupart des récepteurs n'ayant qu'une faible autonomie en énergie.

Dans le cas d'une transmission à courte portée ou en conditions de vue directe (LOS), le traitement numérique du signal peut être simplifié dans la mesure où une égalisation du signal reçu n'est plus nécessaire. Il est alors envisageable de se passer des convertisseurs analogique/numérique ainsi que du circuit numérique, et de synchroniser le récepteur en effectuant une récupération de porteuse dans le domaine analogique.

Une première solution pour récupérer la porteuse à partir du signal reçu consiste à utiliser une boucle de Costas. On trouvera un exemple de récepteur analogique utilisant une boucle de Costas dans l'article de S.J. Huang et al. intitulé « W-band BPSK and QPSK transceivers with Costas-loop carrier recovery in 65-nm CMOS technology », publié dans IEEE Journal of Solid-State Circuits, vol. 46, N° 12, Dec. 2011, pp. 3033-3046. Si un tel récepteur permet d'atteindre des débits de quelques Gb/s en utilisant une modulation QPSK dans la bande W (87 GHz), en revanche la consommation en énergie du récepteur est d'environ 50pJ/bit, soit un ordre de grandeur supérieur à la consommation des récepteurs non cohérents.

Une seconde solution pour récupérer la porteuse à partir du signal reçu consiste à utiliser un oscillateur verrouillé par injection ou ILO (*Injection Locked Oscillator*), comme décrit dans l'article de Z. He et al. intitulé « A 12Gbps analog QPSK baseband receiver based on injection-locked VCO », publié dans Proc. of 2015 IEEE MTT-S International Microwave Symposium, 2015, pp. 1-4. Le principe de fonctionnement en est le suivant : lorsqu'un signal à la fréquence porteuse est directement injecté dans un oscillateur dont la fréquence propre est proche de cette fréquence, celui-ci se met à osciller en se verrouillant en fréquence et en phase sur le signal injecté. Cependant, lorsque le signal injecté est un signal modulé (comme c'est le cas avec le signal reçu), le verrouillage n'est pas efficace et la fréquence d'oscillation de l'ILO est instable, dérivant entre sa fréquence propre et celle du signal injecté

Le chapitre de M.K. Simon et W.C. Lindsey al. "Carrier-Tracking Loops Employing The Phase-Lock Principle", du livre "Telecommunication Systems Engineering", 1 janvier 1973, Englewood Cliffs, Prentice-Hall Inc, US, pages 26 - 84, divulgue des techniques pour la récupération de la phase de la porteuse pour des systèmes de modulation de phase.

Le chapitre de W.C. Lindsey: "Systems Employing The Phase-Lock Or Entrainment Principle", du livre "Synchronization Systems in Communication and Control", 1 janvier 1972, Englewood Cliffs, Prentice-Hall, US, pages 65 - 129, divulgue des techniques pour la récupération de la phase de la porteuse en utilisant le principe de verrouillage de phase.

Le but de la présente invention est par conséquent de proposer une architecture de récepteur cohérent, et plus particulièrement un système analogique de récupération de porteuse, capable de démoduler des signaux ayant un ordre de modulation élevé et d'atteindre des débits de plusieurs dizaines de Gb/s, ce pour une consommation en énergie comparable à celle des récepteurs non cohérents inférieure à 10 pJ/b.

## EXPOSÉ DE L'INVENTION

La présente invention est définie par un système de récupération de porteuse pour récepteur cohérent, tel que revendiqué en revendication 1. Des modes particuliers de réalisations de ce système de récupération de porteuse sont donnés par les revendications dépendantes.

## BRÈVE DESCRIPTION DES DESSINS

D'autres caractéristiques et avantages de l'invention apparaîtront à la lecture d'un mode de réalisation préférentiel de l'invention, décrit en référence aux figures jointes parmi lesquelles :

La Fig. 1 représente de manière schématique l'architecture d'un récepteur cohérent utilisant un système de récupération de porteuse selon l'invention ;
La Fig. 2A représente de manière schématique un premier exemple de circuit de pré-conditionnement de signal pour le système de récupération de porteuse de la Fig. 1 ;
La Fig. 2B représente les spectres de signaux en entrée et en sortie du circuit de la Fig. 2A ;
La Fig. 3A représente de manière schématique un second exemple de circuit de pré-conditionnement de signal pour le système de récupération de porteuse de la Fig. 1 ;
La Fig. 3B représente une implémentation en mode différentiel du circuit de pré-conditionnement de la Fig. 3A ;
La Fig. 4 représente de manière schématique un circuit de pré-conditionnement de signal pour un système de récupération de porteuse selon un premier mode de réalisation de l'invention ;
La Fig. 5 représente de manière schématique un circuit de pré-conditionnement de signal pour un système de récupération de porteuse selon un second mode de réalisation de l'invention ;
Les Figs. 6A-6D représentent de manière schématique différentes variantes du circuit de régénération de porteuse pour le système de récupération de porteuse selon la Fig. 1 ;
La Fig. 7 représente de manière schématique un premier exemple d'implémentation du circuit de régénération de porteuse ;
La Fig. 8A représente de manière schématique un second exemple d'implémentation du circuit de régénération de porteuse ;
La Fig. 8B représente le spectre de signaux en différents points du circuit de régénération de porteuse de la Fig. 8A ;
La Fig. 9A représente de manière schématique un troisième exemple d'implémentation du circuit de régénération de porteuse ;
La Fig. 9B représente le spectre de signaux en différents points du circuit de régénération de porteuse de la Fig. 9A ;
La Fig. 10A représente de manière schématique un exemple d'implémentation du système de récupération de porteuse ;
La Fig. 10B représente le spectre de signaux en différents points du système de récupération de porteuse de la Fig. 10A.

## EXPOSÉ DÉTAILLÉ DE MODES DE RÉALISATION PARTICULIERS

Nous considérerons dans la suite un récepteur de signal N-PSK autrement dit une porteuse modulée par des symboles appartenant à un alphabet de modulation de phase PSK (*Phase ShiftKeying*) d'ordre N. L'alphabet de modu-

$$\left\{ e^{j\frac{2\pi k}{N}} \Big| k = 0, ..., N-1 \right\} .$$

lation est constitué par les symboles complexes

L'idée générale de l'invention est de récupérer la porteuse au moyen d'une première étape d'obtention d'une harmonique non modulée de cette porteuse et d'une seconde étape de verrouillage d'un oscillateur par injection de cette harmonique. En effet, comme on l'a vu plus haut, l'injection directe du signal modulé (ici N-PSK) conduit à une fréquence d'oscillation instable et n'est donc pas utilisable en pratique. L'invention peut être utilisée pour un alphabet de modulation QPSK et est particulièrement avantageuse pour les ordres de modulation élevés, en particulier pour $N \geq 8$ .

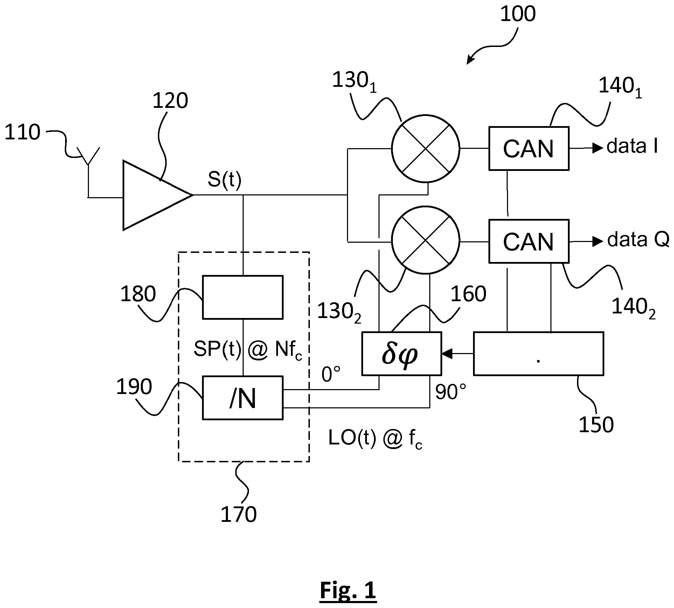

La Fig. 1 représente de manière schématique l'architecture d'un récepteur cohérent, 100, utilisant un système de récupération de porteuse selon l'invention.

Le signal N-PSK reçu par l'antenne 110 est amplifié classiquement par un amplificateur faible bruit 120 avant d'être démodulé en bande de base par deux mélangeurs en quadrature $130_1$, $130_2$, les signaux en bande de base sur les voies I et Q étant ensuite convertis en données numériques par les convertisseurs CAN $140_1$, $140_2$. Optionnellement, un détecteur d'erreur de phase (et le cas échéant d'amplitude), 150, détermine l'erreur d'écart de phase entre les deux voies par rapport à la quadrature (le cas échéant également l'erreur de gain) et corrige cette erreur au moyen d'un déphaseur (le cas échéant, l'erreur de gain au moyen d'un amplificateur) 160, pour fournir deux sinusoïdes en quadrature (et de même amplitude) aux mélangeurs. De nombreux dispositifs de correction de phase et de gain pour démodulateur en quadrature sont connus de l'état de la technique, par exemple de US-B-6 891 440. L'objet de l'invention ne concerne cependant pas un tel dispositif.

Le récepteur, 100, comprend en outre un système de récupération de porteuse 170 constitué d'une part, par un circuit de pré-conditionnement, 180, destiné à générer un signal non modulé à une harmonique supérieure $Nf_c$ de la fréquence porteuse, $f_c$ , à partir du signal N-PSK reçu, et d'autre part, par un régénération de fréquence porteuse, 190, pour générer à partir de cette harmonique deux signaux en quadrature, à la fréquence porteuse $f_c$.

Nous considérerons tout d'abord la structure du circuit de pré-conditionnement du système de récupération de porteuse.

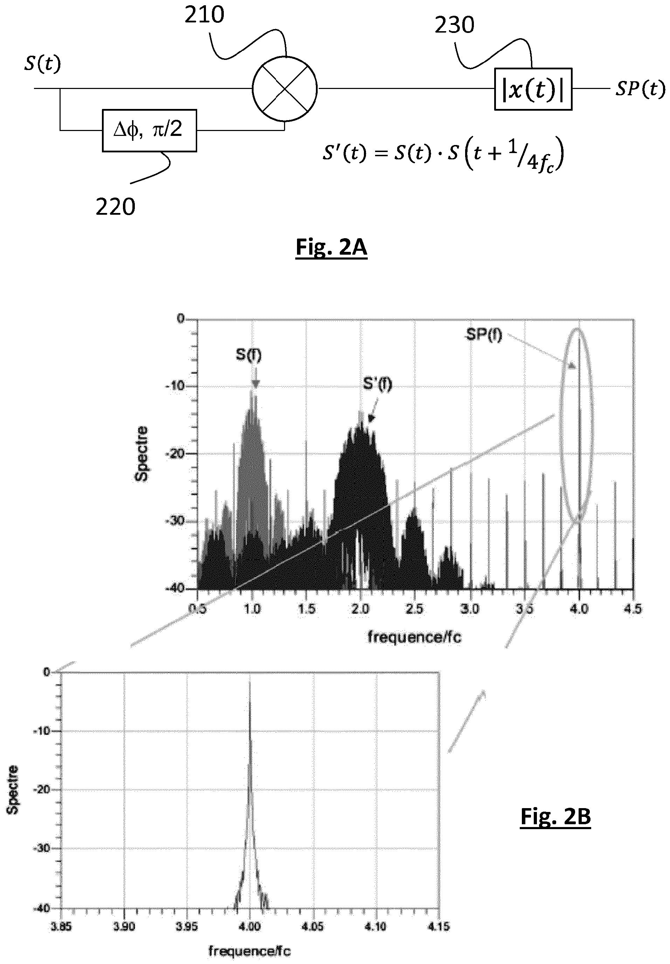

On supposera dans un premier exemple que le signal reçu, $S(t)$ est un signal QPSK, autrement dit $N = 4$, le circuit de pré-conditionnement correspondant étant illustré en Fig. 2A.

Le signal $S(t)$ est mélangé (autrement dit multiplié) dans le mélangeur 210 avec une version de $S(t)$, déphasée de 90°, à la fréquence porteuse $f_c$. De manière équivalente, $T$ le signal $S(t)$ est retardé d'un quart de période de la

$$1/4f_c = \frac{T_c}{4} \, ,$$

fréquence porteuse, soit      dans la ligne à retard 220 avant d'être mélangé avec lui-même. Le signal en sortie du mélangeur est donné par :

$$S'(t) = S(t).S(t + \frac{1}{4f_c}) \tag{1}$$

Ce signal est ensuite redressé par un redresseur 230, qui fournit le module $SP(t) = |S'(t)|$ en sortie du circuit de pré-conditionnement.

Le signal reçu $S(t)$ étant un signal modulé QPSK, celui-ci peut s'exprimer sous la forme:

$$S(t) = A_I \cos\left(2\pi f_c t\right) + A_Q \sin\left(2\pi f_c t\right) \tag{2}$$

où $A_I = \pm 1$ et $A_Q = \pm 1$ sont les amplitudes des symboles QPSK (à un coefficient multiplicatif près) et donc $(A_I)^2 = (A_Q)^2 = 1$.

Il en résulte que le signal préconditionné en sortie du redresseur n'est autre que :

$$SP(t) = \left| S(t).S(t + \frac{1}{4f_c}) \right| = \left| \cos\left(2\pi.2f_c t\right) \right| \tag{3}$$

1 Ce signal préconditionné est donc un signal sinusoïdal redressé, de période $\frac{1}{4f_c}$ (du fait de la présence de la valeur absolue). On a représenté en Fig. 2B les spectres respectifs des signaux $S(t)$, $S'(t)$ et $SP(t)$ où l'on a porté en abscisses la fréquence normalisée par la fréquence porteuse $f_c$ . On remarque que le signal préconditionné comporte, comme prévu, une raie prononcée, centrée sur $4f_c$ alors que le signal QPSK lui-même n'en comporte pas (les symboles de modulation sont statistiquement équidistribués).

Il est à noter que la ligne à retard 220 peut de manière générale introduire un retard de $\left(2p+1\right)\dfrac{T_c}{4}$ où $p$ est un entier positif ou nul, le changement de polarité introduit lorsque $p$ est impair étant neutralisé dans le redresseur.

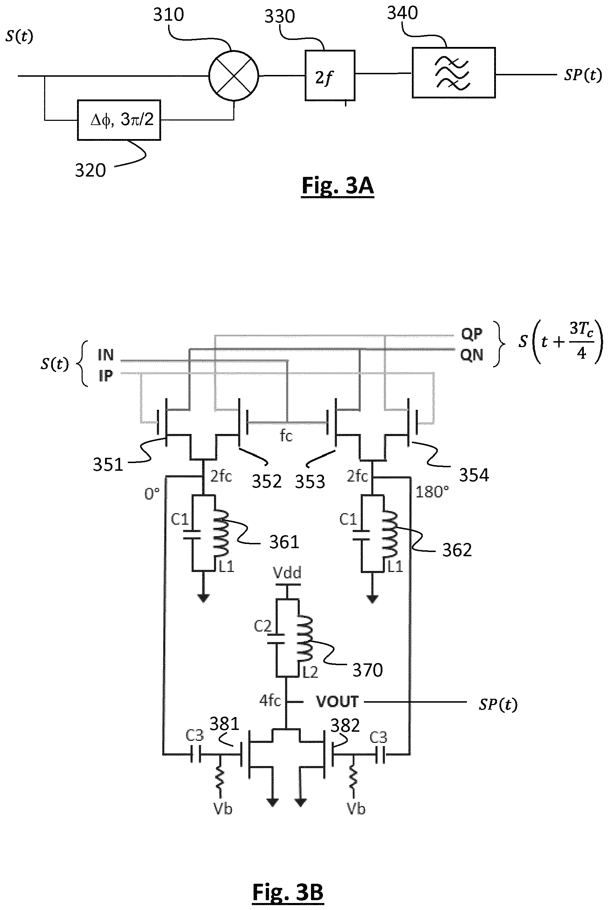

Un second exemple de réalisation de circuit de pré-conditionnement, toujours pour un signal QPSK, est représenté en Fig. 3A.

Dans cet exemple, le signal reçu $S(t)$ est retardé dans la ligne à retard 320 de $\dfrac{3T_c}{4}$ ou de manière plus générale de $\left(2p+1\right)\dfrac{T_c}{4}$ où $p$ est un entier positif impair. Autrement dit, la composante spectrale du signal à $f_c$ est déphasée de $\left(2p+1\right)\dfrac{\pi}{2}$ .

Le signal ainsi retardé est mélangé à lui-même dans le mélangeur 310 et le résultat en sortie du mélangeur est fourni à un doubleur de fréquence, 330, suivi d'un filtre-passe bande, 340, autour de la fréquence $4f_c$. Ce filtre possède de préférence un facteur de qualité élevée de manière à ne laisser passer essentiellement que la composante à $4f_c$.

Ce circuit de pré-conditionnement peut être implémenté en mode différentiel comme représenté en Fig. 3B.

Le signal $S(t)$ est fourni en différentiel sur les grilles d'un premier couple de transistors de mélange, 351, 352, et d'un second couple de transistors de mélange 353,354. Ces transistors ont tous les mêmes caractéristiques et par conséquent les couples de transistors sont équilibrés.

Le signal retardé, $S\left(t+\dfrac{3T_c}{4}\right),$ alimente en différentiel les drains du premier couple de transistors de mélange et du second couple du transistor de mélange.

Un premier circuit oscillant, 361, à la fréquence harmonique double, $2f_c$ , est monté entre une première borne commune reliant les sources des transistors 351,352 et la masse. De manière similaire, un second circuit oscillant, 362, à la fréquence harmonique double, $2f_c$ , est monté entre une seconde borne commune reliant les sources des transistors 353, 354 et la masse. Les transistors 351-354 jouent le rôle du mélangeur 310 dans la Fig. 3A. Avantageusement, les filtres 361 et 362 sélectionnent les harmoniques doubles.

Les signaux de mélange présents à la première borne commune et à la seconde borne commune attaquent en différentiel, via les capacités de découplage C3, les grilles d'un troisième couple de transistors équilibrés, 381,382 dont les drains sont reliés à une troisième borne commune. Un troisième circuit oscillant, 370, à la fréquence harmonique $4f_c$ est monté entre cette troisième borne commune et l'alimentation. Le troisième couple de transistors joue le rôle de doubleur de fréquence, 330 et le troisième circuit oscillant joue le rôle de filtre passe-bande à haut facteur de qualité, 340, de la Fig. 3A.

Le signal de sortie présent à la troisième borne commune est le signal préconditionné, $SP(t),$ à la fréquence harmonique, $4f_c$, débarrassé de la modulation QPSK.

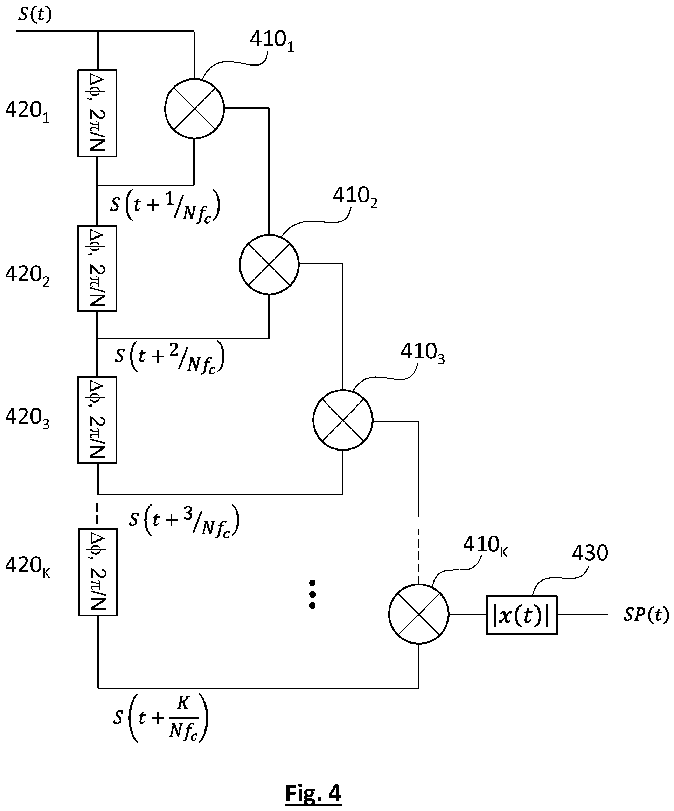

Plus généralement, la Fig. 4 représente un circuit de pré-conditionnement de signal pour un système de récupération de porteuse, selon un premier mode de réalisation de l'invention, lorsque le signal reçu est un signal N-PSK.

Le circuit de pré-conditionnement comprend une batterie de $K = \dfrac{N}{2}-1$ (où N est une valeur paire) mélangeurs en cascade, $410_1,...,410_K$, et une série de $K$ lignes à retard associées, $420_1,...,420_K$, chaque ligne à retard, $420_k$, introduisant un retard élémentaire de $\dfrac{T_c}{N}$ représentant une fraction $\dfrac{1}{N}$ de la période de la porteuse. En d'autres termes, chaque ligne à retard, $420_k$, peut être considéré comme un déphaseur introduisant un déphasage élémentaire de $\dfrac{2\pi}{N}$ à la fréquence $f_c$ . Le signal en sortie d'une ligne à retard est fourni d'une part à l'entrée de la ligne à retard suivante de la série et d'autre part à une entrée du mélangeur associé, $410_k$, du même étage k.

La première ligne à retard $420_1$ reçoit directement le signal $S(t)$ en entrée du circuit de pré-conditionnement.

Chaque mélangeur $410_k$ effectue une multiplication entre la sortie du mélangeur précédent $410_{k-1}$ et la sortie de la $k^{\text{ème}}$ ligne à retard de la série, $420_k$.

La sortie du dernier mélangeur, $410_K$, est reliée à l'entrée du redresseur, 430.

Le signal préconditionné $SP(t)$ en sortie du circuit du redresseur s'exprime en définitive sous la forme :

$$SP(t) = \left| \prod_{k=0}^{\frac{N}{2}-1} S\left( t + \frac{k}{Nf_c} \right) \right| \tag{4}$$

Il convient de noter, comme précédemment, que chaque ligne à retard peut introduire plus généralement un retard de $(2p+1)\dfrac{T_c}{4}$ où $p$ est un nombre entier positif ou nul, dans la mesure où le changement de polarité éventuel en sortie du dernier mélangeur est neutralisé par le redresseur.

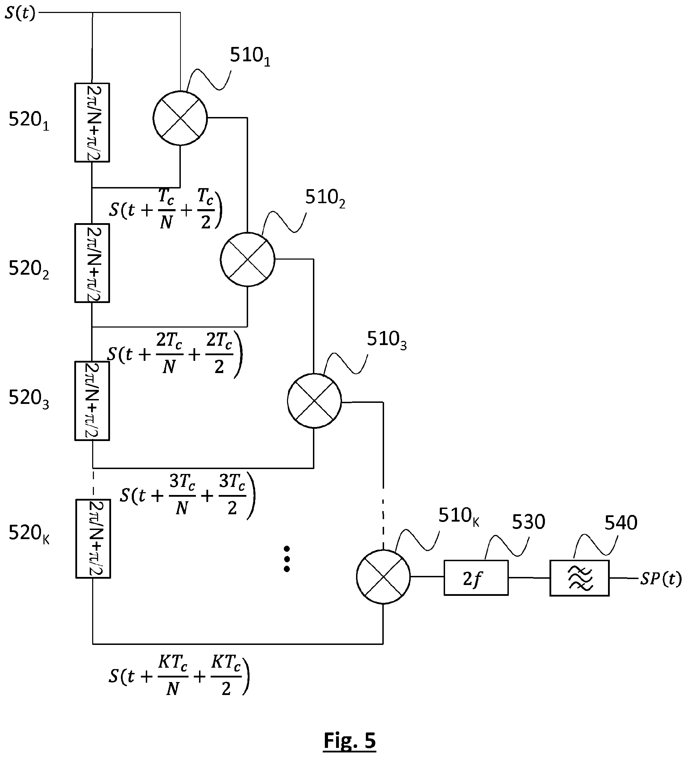

La Fig. 5 représente un circuit de pré-conditionnement de signal pour un système de récupération de porteuse, selon un second mode de réalisation de l'invention, lorsque le signal reçu est un signal N-PSK.

Le circuit de pré-conditionnement comprend une batterie de $K = \dfrac{N}{2} - 1$ (où N est une valeur paire) mélangeurs en cascade, $510_1,...,510_K$, et une série de K lignes à retard associées, $520_1,...,520_K$, chaque ligne à retard, $520_k$, $k = 1,...,K$ introduisant un même retard élémentaire de $\dfrac{T_c}{N} + \dfrac{T_c}{2}$. Le signal en sortie d'une ligne à retard $520_k$, $k = 1,...,K$ est fourni d'une part à l'entrée de la ligne à retard suivante de la série et d'autre part à une entrée du mélangeur associé, $510_k$, du même étage k.

Le signal en sortie du dernier étage, c'est-à-dire du mélangeur $510_K$, est fourni au doubleur de fréquence 530 puis au filtre passe-bande à facteur de qualité élevé, 540, centré sur la fréquence $Nf_c$.

Comme indiqué précédemment, les différents retards élémentaires sont définis à un multiple impair près de $\dfrac{T_c}{2}$.

La structure des mélangeurs $510_1,...,510_K$ peut être similaire à l'étage de mélange illustré dans la partie haute en Fig. 3B. Le signal d'entrée $IN,IP$ d'un mélangeur $510_k$ attaquant les grilles des transistors des premier et second couples de transistors est celui en entrée de l'étage k et celui alimentant les drains de ces transistors est celui en sortie de la ligne à retard $520_k$. Les premier et second circuits oscillants du mélangeur $510_k$ sélectionnent les harmoniques à la fréquence $kf_c$ (résonance à $kf_c$). Les signaux présents sur les première et seconde bornes communes représentent le signal de sortie du mélangeur $510_k$. Le dernier mélangeur $510_K$ est associé à un doubleur de fréquence et un troisième circuit oscillant comme représenté en Fig. 3B, le troisième circuit oscillant étant ici destiné à filtrer les harmoniques de fréquence $Nf_c$ (résonance à $Nf_c$).

Comme décrit précédemment en relation avec les Figs. 4 et 5, le circuit de pré-conditionnement de signal applique au résultat de la multiplication des différents signaux retardés, soit un redressement (430), soit un doublement de fréquence (530). De manière plus générale, l'homme du métier comprendra que l'on peut appliquer une fonction quadratique (ou de manière équivalente une non-linéarité d'ordre 2) au résultat de ladite multiplication en vue d'obtenir le même résultat.

Le circuit de régénération de porteuse sera maintenant décrit ci-après.

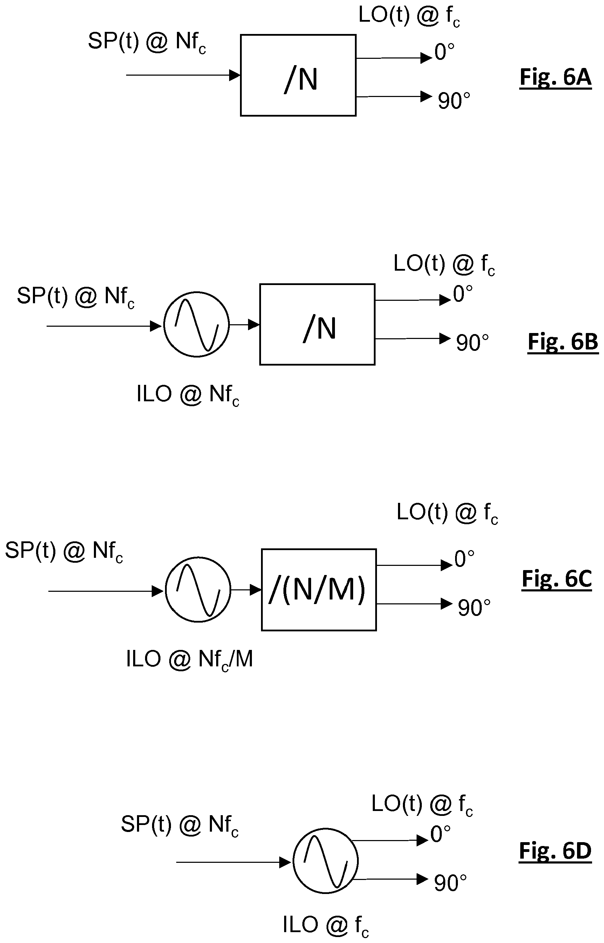

Selon une première variante, représentée en Fig. 6A, le circuit de régénération de porteuse peut être un simple diviseur de fréquence de rang N, apte à fournir deux signaux sinusoïdaux en quadrature à la fréquence $f_c$. Pour de très hautes fréquences, de l'ordre de plusieurs dizaines de GHz, on utilisera avantageusement un diviseur de fréquence verrouillé en injection ou ILFD (*Injection Locked Frequency Divider*) suivi d'un ou de plusieurs diviseurs de fréquence utilisant une logique de commutation de courant ou CML (*Current Mode Logic*) et/ou des diviseurs de fréquence conventionnels à base de bascules CMOS. Les diviseurs de fréquences CML peuvent être employés jusqu'à des fréquences de l'ordre de 30 GHz et ceux à base de bascules CMOS jusqu'à quelques GHz. Ainsi, un premier rang de division peut être réalisé à l'aide d'un diviseur ILFD, un second par un diviseur CML et un troisième, si besoin, par un diviseur CMOS, étant entendu que le produit des facteurs de division successifs est choisi égal à N.

Selon une seconde variante, représentée par les exemples en Figs. 6B à 6D, le circuit de régénération de porteuse est réalisé à partir d'un oscillateur verrouillé par injection (ILO) du signal préconditionné, $SP(t)$.

Dans l'exemple de la Fig. 6B, le signal préconditionné $SP(t)$ est injecté dans l'oscillateur ILO. Le verrouillage de phase de l'oscillateur sur la N$^{ième}$ harmonique se traduit par une réjection des parties du spectre contenant une modulation de phase et la régénération d'un signal non modulé, purement sinusoïdal à la fréquence $Nf_c$. Ce signal est ensuite divisé en fréquence par un facteur N pour produire deux signaux en quadrature comme décrit précédemment en relation avec la Fig. 6A.

Dans l'exemple de la Fig. 6C, le signal préconditionné $SP(t)$ est injecté dans l'oscillateur ILO et celui-ci oscille librement à une fréquence $Nf_c/M$ où $M$ est un diviseur entier de $N$, en se verrouillant en phase sur la composante à $Nf_c$ du signal injecté. Ainsi, l'oscillateur ILO se comporte comme un diviseur de fréquence ILFD. Il effectue à la fois la réjection des parties du spectre modulées en phase et une première division de fréquence, d'un facteur $M$. Cet oscillateur est suivi d'un diviseur de fréquence classique, par exemple à bascules CMOS, pour effectuer une division par le facteur restant $N/M$ et régénérer ainsi la porteuse.

Enfin, dans l'exemple de la Fig. 6D, le signal préconditionné $SP(t)$ est injecté dans l'oscillateur ILO et celui-ci oscille librement à la fréquence $f_c$ en se verrouillant en phase sur la composante à $Nf_c$ du signal injecté. L'oscillateur se comporte comme un diviseur de fréquence ILFD de facteur $N$ et les signaux en quadrature à la fréquence $f_c$ sont directement fournis par l'oscillateur sans qu'il soit nécessaire de prévoir un étage de division supplémentaire.

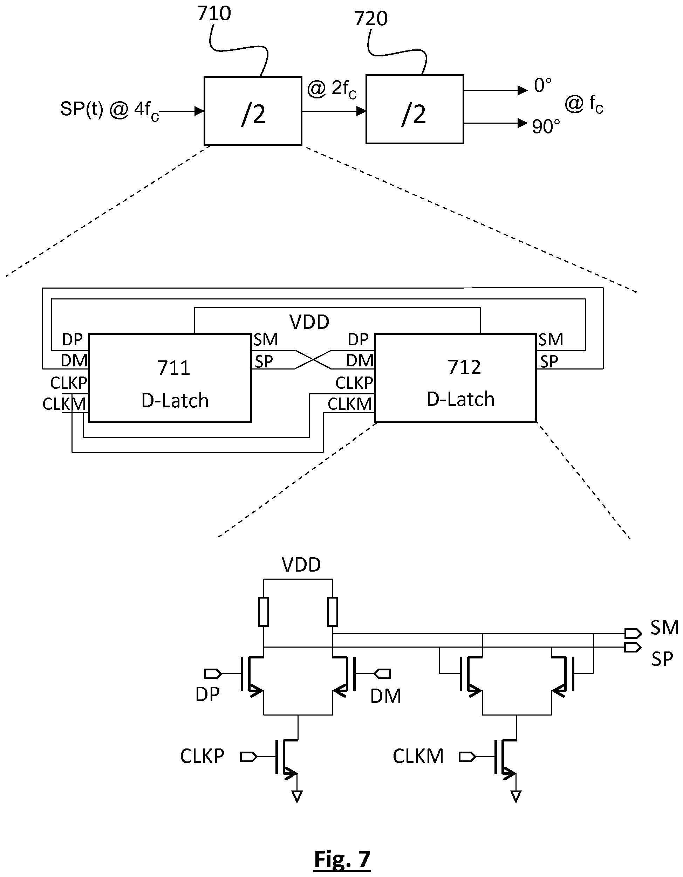

La Fig. 7 représente de manière schématique un premier exemple d'implémentation du circuit de régénération de porteuse.

Ce circuit est conforme à la première variante décrite précédemment en relation avec la Fig. 6A. Dans le cas présent, il s'agit d'un diviseur de fréquence de facteur 4, adapté par conséquent à un système de récupération de porteuse pour un signal QPSK. Le circuit de régénération est constitué de deux diviseurs de fréquence par 2, 710 et 720, montés en cascade. Chaque diviseur de fréquence par 2 est réalisé en logique CML, au moyen de deux bascules 711 et 712, montées en boucle, les sorties de données de l'une (SM, SP) étant croisées pour fournir les entrées de données (DM, DP) de l'autre, les signaux d'horloge d'une bascule (CKP, CKM) étant également inversés par rapport aux signaux d'horloge de l'autre. Le détail d'une bascule a été représenté en bas de la figure, la partie gauche (maître) comprenant une paire de transistors (*sample and hold*) contrôlant la partie gauche (esclave), de manière connue en soi.

Le signal préconditionné *SP(t)* est utilisé en mode différentiel comme signal d'horloge (CKM, CKP) de la première bascule, 711, du premier diviseur de fréquence par 2 et le signal à la fréquence porteuse est fourni par la seconde bascule (non représentée) du second diviseur de fréquence par 2, 720. En pratique, pour générer les deux signaux en quadrature, on utilisera deux seconds diviseurs de fréquence par 2, recevant les sorties SM, SP du premier diviseur par 2, les entrées des deux seconds diviseurs étant croisées entre elles.

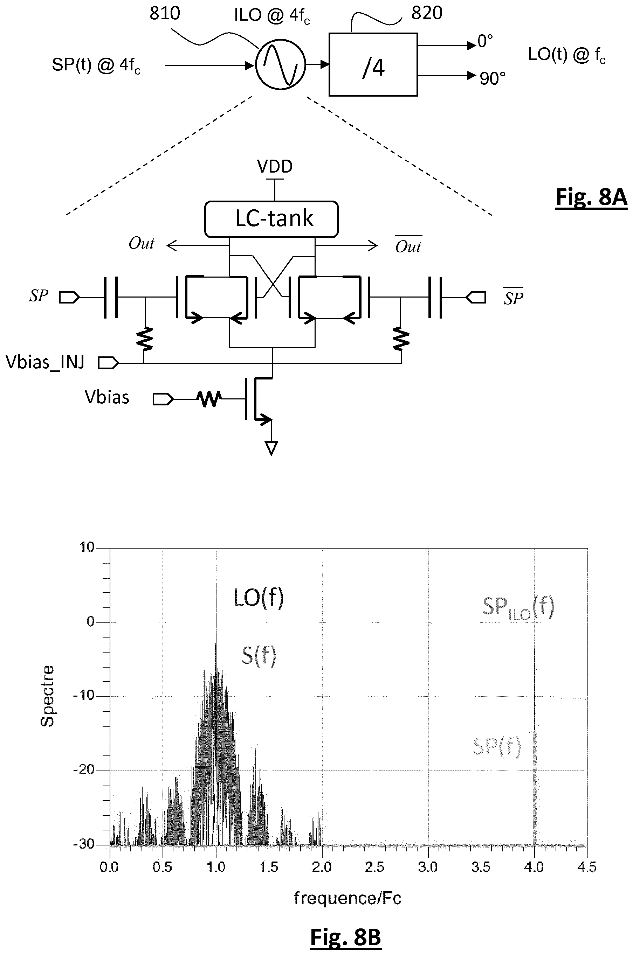

La Fig. 8A représente de manière schématique un second exemple d'implémentation du circuit de régénération de porteuse pour un signal QPSK.

Ce circuit est conforme à la seconde variante décrite précédemment, en relation avec la Fig. 6B. Il comprend un oscillateur verrouillé par injection (ILO), 810, fonctionnant autour de la fréquence $4f_c$ et verrouillé sur la raie $4f_c$ du signal préconditionné, $SP(t)$. Autrement dit, la fréquence $4f_c$ se trouve dans l'intervalle de verrouillage (*lock-in range*) de l'oscillateur ILO. Il régénère la raie à $4f_c$ du signal $SP(t)$ (ainsi que le bruit de phase autour de cette raie) et rejette les parties résiduelles du spectre correspondant à de la modulation de phase. La structure de l'oscillateur ILO, 810, est détaillée en bas de la figure. Il est basé sur un oscillateur à paire croisée différentiel utilisant un circuit résonant LC (LC-tank). Le signal $SP(t)$ est injecté en différentiel dans l'oscillateur. Celui-ci se verrouille sur la raie de plus forte puissance se situant dans son intervalle de verrouillage, à savoir la raie à $4f_c$ du signal $SP(t)$. Le signal différentiel en sortie ($Out, \overline{Out}$) recopie cette raie. Il est ensuite divisé par un diviseur de fréquence de facteur 4, 820, tel que par exemple le diviseur à logique CML de la Fig. 7.

La Fig. 8B représente le spectre de signaux intervenant dans le circuit de régénération de porteuse de la Fig. 8A. On a tout d'abord représenté le spectre $S(f)$ du signal QPSK reçu. Ce spectre est relativement étalé en raison de la modulation de phase. Le signal reçu est préconditionné par un circuit de pré-conditionnement comme illustré en Fig. 4 ou 5 (avec N=4) pour fournir un signal préconditionné dont le spectre $SP(f)$ est également représenté en Fig. 8B. Comme on l'a vu, ce spectre comporte une raie très prononcée, centrée sur $4f_c$ (avec un bruit de phase autour), sur laquelle se verrouille l'oscillateur ILO. Le signal en sortie de l'oscillateur ILO, 810, désigné par $SP_{ILO}(f)$, se présente sous forme d'une raie intense et fort rapport signal sur bruit. La fréquence de ce signal est divisée par un facteur 4 dans le diviseur de fréquence 820 pour donner un signal de porteuse récupérée, dont le spectre est représenté par $LO(f)$. Il peut être utilisé directement dans l'étage de démodulation en bande de base du récepteur 100.

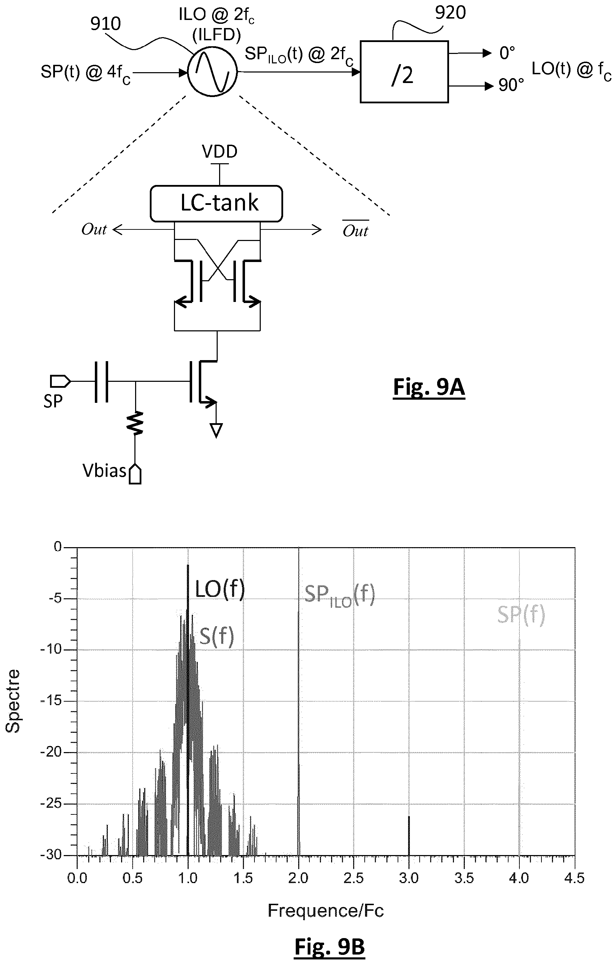

La Fig. 9A représente de manière schématique un troisième exemple d'implémentation du circuit de régénération de porteuse pour un signal QPSK.

Ce circuit est conforme à la seconde variante décrite précédemment, en relation avec la Fig. 6C. Il comprend un oscillateur (ILO) 910, fonctionnant autour de la fréquence $2f_c$. Il est basé sur un oscillateur à paire croisée différentiel utilisant un circuit résonant LC (LC-tank) et verrouillé par injection sur son mode commun (en push-push), au moyen du signal préconditionné, *SP(t)*, comme indiqué dans la partie basse de la figure.

L'oscillateur ILO oscille à la fréquence $2f_c$ et est verrouillé en phase sur la composante à $4f_c$ du signal *SP(t)*, représenté en Fig. 9B, le reste du spectre correspondant à un signal résiduel modulé en phase, étant rejeté. Il agit ainsi comme un premier diviseur de fréquence à verrouillage par injection ou ILFD, régénérant à la fois la raie du signal à $4f_c$ de *SP(t)* et divisant sa fréquence par 2. Le signal en sortie de l'oscillateur, de spectre $SP_{ILO}(f)$, est ensuite divisé en fréquence d'un facteur 2, par exemple au moyen d'un diviseur à logique CML de la Fig. 7, pour fournir le signal de porteuse récupérée, dont le spectre, *LO(f)* a également été représenté en Fig. 9B.

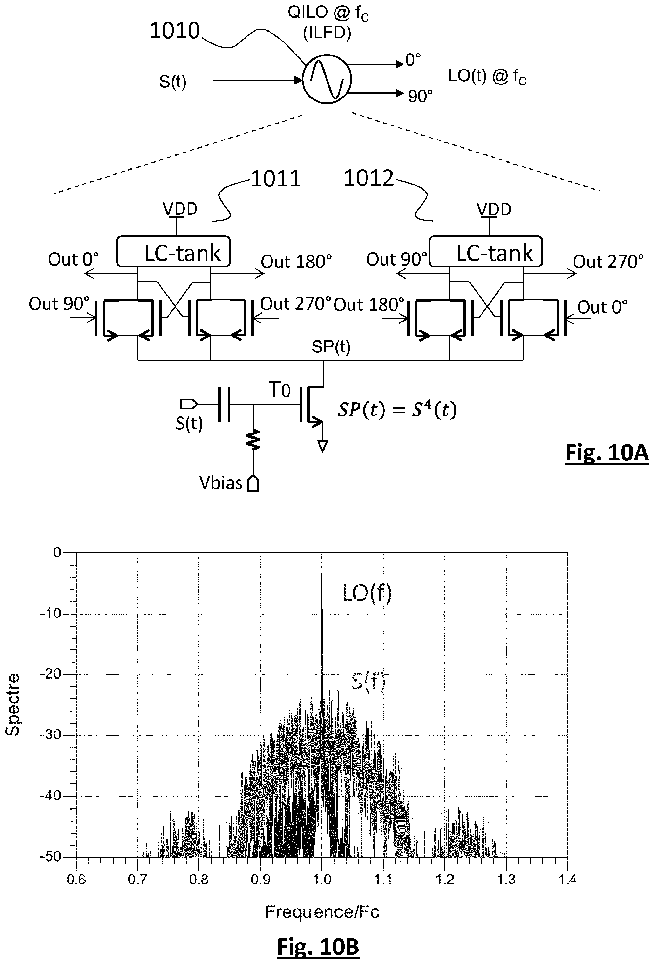

La Fig. 10A représente de manière schématique un exemple d'implémentation du système de récupération de porteuse pour un signal QPSK.

Ce circuit est conforme à la seconde variante décrite précédemment, en relation avec la Fig. 6D. Il comprend un circuit oscillant verrouillé par injection (ILO), 1010, recevant cette fois-ci directement le signal modulé QPSK, *S(t).* Ce signal est préconditionné dans le circuit oscillant lui-même comme indiqué en bas de la figure. On tire ici parti du fait que le transistor MOS, $T_0$, est polarisé (par $V_{bias}$) de manière à fonctionner en régime non linéaire, autrement dit la caractéristique $I_{DS} = f(V_{GS})$ est exploitée dans une zone non-linéaire, ce qui donne lieu à des contributions de courant en $S^2(t)$, $S^3(t)$, $S^4(t)$,... correspondant au développement de Taylor de la fonction $f$. Les contributions en $S(t)$, $S^2(t)$, $S^3(t)$, sont modulées en phase alors que, pour un signal QPSK, la contribution en $S^4(t)$ présente une composante à $4f_c$ non modulée. En outre, cette composante non modulée est de plus forte puissance (celle à $8f_c$ est de plus faible puissance). En définitive, on comprendra que le transistor d'injection $T_0$ avec son circuit de polarisation à $V_{bias}$ joue le rôle d'un circuit de pré-conditionnement. Le transistor $T_0$ reçoit sur sa grille le signal modulé en phase *S(t)* après suppression de sa composante DC par un condensateur de liaison.

Le circuit oscillant comprend en outre un circuit de régénération de porteuse constitué par deux oscillateurs à paire croisée différentiels en quadrature, 1011, 1012, utilisant des circuits résonants LC (LC-tank), dont la fréquence de résonance est proche de $f_c$. Ces oscillateurs en quadrature se verrouillent par injection de courant en mode commun (en mode 4-push, i.e. on injecte 4 fois par période de l'oscillateur ILO), sur la raie de plus forte puissance à $4f_c$, présente dans le signal préconditionné *SP(t).* Les signaux de sortie $Out_{0°}$, $Out_{180°}$ d'une part, et $Out_{90°}$, $Out_{270°}$ d'autre part, sont fournis en différentiel aux mélangeurs en quadrature du démodulateur en bande de base.

On a représenté en Fig. 10B le spectre du signal reçu, *S(t),* injecté dans le circuit oscillant et celui du signal à la fréquence porteuse *LO(f)* (c'est-à-dire le spectre de $Out_{0°}$ -$Out_{180°}$ ou $Out_{90°}$ -$Out_{270°}$).

L'homme du métier comprendra que l'exemple d'implémentation du système de récupération de porteuse illustré en Figs. 10A-10B est particulièrement compact et efficace.

On notera que le système de récupération de porteuse selon la présente invention est réalisé entièrement en analogique et permet donc de se passer avantageusement de dispositifs de traitement numérique du signal.

Le système de récupération de porteuse selon l'invention trouve à s'appliquer notamment dans le contexte des communications à haut débit et courte portée ne nécessitant qu'une très faible consommation d'énergie. Elle permet par exemple de remplacer efficacement des câbles et des connecteurs entre dispositifs fixes ou mobiles (par exemple en milieu industriel). Elle permet aussi de réaliser des smartphones, tablettes, phablettes, complètement hermétiques en supprimant totalement les connecteurs USB traditionnels et en effectuant la recharge par induction. Enfin, elle peut s'appliquer à des liaisons de communication à plus longue distance, pour lesquelles la réduction de consommation au niveau du récepteur est essentielle, comme par exemple dans le domaine de l'Internet des Objets (IoT).

**Revendications**

1. Système de récupération de porteuse pour récepteur cohérent destiné à recevoir un signal modulé en phase, *S(t),* au moyen d'une modulation *N* -PSK de ladite porteuse où *N* est un nombre pair, **caractérisé en ce qu'**il comprend :

un circuit de pré-conditionnement (180) de signal pour fournir un signal préconditionné possédant une composante non modulée à une harmonique $Nf_c$ de la fréquence porteuse $f_c$, ladite composante non modulée à $Nf_c$

$$K = \frac{N}{2} - 1$$

étant obtenue par multiplication du signal modulé en phase et de             versions retardées de ce signal par des retards respectifs $k\dfrac{T_c}{N}$, avec $k = 1,..,K$, chaque retard étant défini à un multiple entier près de $\dfrac{T_c}{2}$, où $T_c = 1/f_c$ le résultat de ladite multiplication étant soumis à une fonction quadratique ;

un circuit de régénération de porteuse (190) pour générer un signal sinusoïdal à la fréquence porteuse en se verrouillant en phase sur ladite harmonique.

2. Système de récupération de porteuse selon la revendication 1, **caractérisé en ce que** le circuit de pré-conditionnement de signal obtient le signal préconditionné au moyen de

$$SP(t) = \left| \prod_{k=0}^{\frac{N}{2}-1} S\left( t + \frac{kT_c}{N} \right) \right|.$$

3. Système de récupération de porteuse selon la revendication 2, **caractérisé en ce que** le circuit de pré-conditionnement de signal comprend une pluralité $K$ d'étages, chaque étage (k) comprenant un retard ($420_k$) de valeur $\dfrac{T_c}{N}$, et un mélangeur ($410_k$), le mélangeur d'un étage courant (k) multipliant le signal fourni par le mélangeur ($410_{k-1}$) de l'étage précédent (k-1) avec le signal en sortie du retard ($420_{k-1}$) de l'étage précédent, après l'avoir retardé par le retard ($420_{k-1}$) de l'étage courant (k), le premier étage recevant ledit signal modulé en phase, le signal en sortie du mélangeur du dernier étage ($410_K$) étant redressé au moyen d'un redresseur (430) pour fournir le signal préconditionné ($SP(t)$).

4. Système de récupération de porteuse selon la revendication 2, **caractérisé en ce que** le circuit de pré-conditionnement de signal comprend une pluralité $K$ d'étages, chaque étage (k) comprenant un retard ($520_k$) de valeur $\dfrac{T_c}{N} + \dfrac{T_c}{2}$, et un mélangeur ($510_k$), le mélangeur d'un étage courant (k) multipliant le signal fourni par le mélangeur ($510_{k-1}$) de l'étage précédent (k-1) avec le signal en sortie du retard ($520_{k-1}$) de l'étage précédent, après l'avoir retardé par le retard ($520_k$) de l'étage courant (k), le premier étage recevant ledit signal modulé en phase, le signal en sortie du mélangeur du dernier étage ($510_K$) étant fourni à un circuit doubleur de fréquence (530), suivi d'un filtre passe-bande ne laissant passer que ladite harmonique $Nf_c$ pour fournir le signal préconditionné, $SP(t)$.

5. Système de récupération de porteuse selon la revendication 2, **caractérisé en ce que** chaque mélangeur d'un étage courant (k) comprend une première paire de transistors (351, 352) et une seconde paire de transistors (353,354), les grilles des transistors de la première paire et les grilles de transistors de la seconde paire recevant en différentiel le signal de sortie du mélangeur de l'étage précédent (k-1), les drains des transistors de la première paire et les drains des transistors de la seconde paire recevant en différentiel le signal en sortie du retard ($520_k$) de l'étage courant (k), le signal de sortie de l'étage courant ($520_k$) étant fourni en différentiel par le signal sur la première borne commune des sources des transistors de la première paire et le signal sur la seconde borne commune des sources des transistors de la seconde paire.

6. Système de récupération de porteuse selon la revendication 2, **caractérisé en ce que** chaque mélangeur d'un étage courant $k = 1,...,K$ comprend un premier circuit oscillant entre la première borne commune et la masse et un second circuit oscillant entre la seconde commune et la masse, le premier circuit oscillant et le circuit oscillant ne laissant passer que l'harmonique à la fréquence $kf_c$.

7. Système de récupération de porteuse selon l'une des revendications précédentes, **caractérisé en ce que** le circuit de régénération de porteuse est un diviseur de fréquence de facteur $N$.

8. Système de récupération de porteuse selon la revendication 7, **caractérisé en ce qu'**il comprend un diviseur de fréquence verrouillé en injection suivi d'au moins un diviseur de fréquence utilisant une logique de commutation de courant CML et/ou au moins un diviseur de fréquence à base de bascules CMOS, le produit des facteurs de division de fréquence de ces diviseurs étant égal à $N$.

**9.** Système de récupération de porteuse selon l'une des revendications 1 à 6, **caractérisé en ce que** le circuit de régénération de porteuse comprend un oscillateur à verrouillage par injection fonctionnant à la fréquence $Nf_c$, suivi d'un diviseur de fréquence de facteur $N$, l'oscillateur se verrouillant en phase sur ladite composante non modulée à $Nf_c$ du signal préconditionné et fournissant un signal purement sinusoïdal à la fréquence $Nf_c$, le diviseur de fréquence divisant la fréquence de ce signal purement sinusoïdal d'un facteur $N$ pour régénérer la porteuse.

**10.** Système de récupération de porteuse selon l'une des revendications 1 à 6, **caractérisé en ce que** le circuit de régénération de porteuse comprend un oscillateur à verrouillage par injection fonctionnant à la fréquence $\dfrac{N}{M} f_c$, où $M$ est un diviseur entier de $N$, suivi d'un diviseur de fréquence de facteur $\dfrac{N}{M}$, l'oscillateur se verrouillant en fréquence et phase sur ladite composante non modulée à $Nf_c$ du signal préconditionné et fournissant un signal purement sinusoïdal à la fréquence $\dfrac{N}{M} f_c$, le diviseur de fréquence divisant la fréquence de ce signal purement sinusoïdal d'un facteur $\dfrac{N}{M}$ pour régénérer la porteuse.

**11.** Système de récupération de porteuse selon la revendication 10, **caractérisée en ce que** le signal modulé en phase est un signal QPSK, l'oscillateur à verrouillage par injection (910) étant un oscillateur à paire croisée différentiel comprenant un circuit résonnant LC, dont la fréquence de résonance est proche de $2f_c$, l'injection du signal préconditionné étant réalisée en mode commun, le diviseur de fréquence divise la fréquence du signal différentiel en sortie de l'oscillateur d'un facteur 2.

**12.** Système de récupération de porteuse selon l'une des revendications 1 à 6, **caractérisé en ce que** le circuit de régénération de porteuse comprend un oscillateur à verrouillage par injection fonctionnant à la fréquence $f_c$, l'oscillateur se verrouillant en fréquence et phase sur ladite composante non modulée à $Nf_c$ du signal préconditionné et fournissant un signal sinusoïdal à la fréquence $f_c$ pour régénérer la porteuse.

**13.** Système de récupération de porteuse selon la revendication 12, **caractérisé en ce que** le circuit de régénération de fréquence comprend deux oscillateurs à paire croisée différentiels en quadrature (1011,1012), utilisant des circuits résonants LC, dont la fréquence de résonance est proche de $f_c$, les oscillateurs en quadrature se verrouillant par injection en mode commun, ladite injection en mode commun étant réalisée par le circuit de pré-conditionnement, comprenant un transistor ($T_0$) polarisé de sorte que son point de polarisation appartienne à une partie non linéaire de sa caractéristique courant drain-source en fonction de sa tension grille source, ledit transistor recevant sur sa grille, à travers un condensateur de liaison, le signal modulé en phase.

**Patentansprüche**

**1.** System zur Trägerrückgewinnung für einen kohärenten Empfänger, der dazu ausgelegt ist, ein Signal $S(t)$ zu empfangen, das mittels einer Modulation $N$-PSK des Trägers phasenmoduliert ist, wobei $N$ eine gerade Zahl ist, **dadurch gekennzeichnet, dass** es umfasst:

eine Signalvorkonditionierungsschaltung (180), zum Bereitstellen eines vorkonditionierten Signals, das eine nicht-modulierte Komponente mit einer harmonischen $Nf_c$ der Trägerfrequenz $f_c$ besitzt, wobei die nicht-modulierte Komponente mit $Nf_c$ erhalten ist durch Multiplikation des phasenmodulierten Signals und von $K = \dfrac{N}{2} - 1$ Versionen, die von diesem Signal um jeweilige Verzögerungen $k \dfrac{T_c}{N}$ verzögert sind, mit $k =$

1,..,K, wobei jede Verzögerung bis auf ein ganzzahliges Vielfaches von $\dfrac{T_c}{2}$ definiert ist, 2 wobei $T_c = 1/f_c$, wobei das Resultat der Multiplikation einer quadratischen Funktion unterworfen ist ;
eine Trägerregenerationsschaltung (190) zum Generieren eines sinusförmigen Signals mit der Trägerfrequenz durch Phasenverriegelung auf der Harmonischen.

2. System zur Trägerrückgewinnung nach Anspruch 1, **dadurch gekennzeichnet, dass** die Signalvorkonditionie-

$$SP(t) = \left| \prod_{k=0}^{\frac{N}{2}-1} S\left( t + \frac{kT_c}{N} \right) \right| .$$

rungsschaltung das vorkonditionierte Signal erhält mittels

3. System zur Trägerrückgewinnung nach Anspruch 2, **dadurch gekennzeichnet, dass** die Signalvorkonditionierungsschaltung eine Mehrzahl K von Stufen umfasst, wobei jede Stufe (k) eine Verzögerung ($420_k$) mit Wert $\dfrac{T_c}{N}$ umfasst, und einen Mischer ($410_k$), wobei der Mischer einer momentanen Stufe (k) das Signal, das durch den Mischer ($410_{k-1}$) der vorhergehenden Stufe (k-1) bereitgestellt wird, mit dem Ausgangssignal der Verzögerung ($420_{k-1}$) der vorhergehenden Stufe multipliziert, nachdem er es um die Verzögerung ($420_{k-1}$) der vorhergehenden Stufe (k) verzögert hat, wobei die erste Stufe das phasenmodulierte Signal empfängt, wobei das Signal am Ausgang des Mischers der letzten Stufe ($410_K$) mit Hilfe eines Gleichrichters (430) gleichgerichtet wird, um das vorkonditionierte Signal ($SP(t)$) bereitzustellen.

4. System zur Trägerrückgewinnung nach Anspruch 2, **dadurch gekennzeichnet, dass** die Signalvorkonditionierungsschaltung eine Mehrzahl $K$ von Stufen umfasst, wobei jede Stufe (k) eine Verzögerung ($520_k$) mit Wert $\dfrac{T_c}{N} + \dfrac{T_c}{2}$ umfasst, und einen Mischer ($510_k$), wobei der Mischer einer momentanen Stufe (k) das Signal, das durch den Mischer ($510_{k-1}$) der vorhergehenden Stufe (k-1) bereitgestellt wird, mit dem Ausgangssignal der Verzögerung ($520_{k-1}$) der vorhergehenden Stufe multipliziert, nachdem er es um die Verzögerung ($520_k$) der momentanen Stufe (k) verzögert hat, wobei die erste Stufe das phasenmodulierte Signal empfängt, wobei das Signal am Ausgang des Mischers der letzten Stufe ($510_K$) einer Frequenzverdopplerschaltung (530) bereitgestellt wird, auf die ein Bandpassfilter folgt, das nur die Harmonische $Nf_c$ passieren lässt, um das vorkonditionierte Signal $SP(t)$ bereitzustellen.

5. System zur Trägerrückgewinnung nach Anspruch 2, **dadurch gekennzeichnet, dass** jeder Mischer einer momentanen Stufe (k) ein erstes Paar von Transistoren (351, 352) und ein zweites Paar von Transistoren (353, 354) umfasst, wobei die Gates der Transistoren des ersten Paars und die Gates von Transistoren des zweiten Paars differentiell das Ausgangssignal des Mischers der vorhergehenden Stufe (k-1) empfangen, wobei die Drains der Transistoren des ersten Paars und die Drains der Transistoren des zweiten Paars differentiell das Ausgangssignal der Verzögerung ($520_k$) der momentanen Stufe (k) empfangen, wobei das Ausgangssignal der momentanen Stufe ($520_k$) differentiell durch das Signal am ersten gemeinsamen Anschluss der Sources der Transistoren des ersten Paars und das Signal am zweiten gemeinsamen Anschluss der Sources der Transistoren des zweiten Paars bereitgestellt ist.

6. System zur Trägerrückgewinnung nach Anspruch 2, **dadurch gekennzeichnet, dass** jeder Mischer einer momentanen Stufe $k = 1,...,K$ eine erste Oszillatorschaltung zwischen dem gemeinsamen Anschluss und der Masse und eine zweite Oszillatorschaltung zwischen dem zweiten gemeinsamen Anschluss und der Masse umfasst, wobei die erste Oszillatorschaltung und die Oszillatorschaltung nur die Harmonische mit der Frequenz $kf_c$ passieren lassen.

7. System zur Trägerrückgewinnung nach einem der vorhergehenden Ansprüche, **dadurch gekennzeichnet, dass** die Trägerregenerationsschaltung ein Frequenzteiler mit Faktor $N$ ist.

8. System zur Trägerrückgewinnung nach Anspruch 7, **dadurch gekennzeichnet, dass** es einen injektionsverriegelten Frequenzteiler umfasst, auf den wenigstens ein Frequenzteiler folgt, der eine CML-Stromschaltlogik verwendet, und/oder wenigstens ein Frequenzteiler auf Basis von CMOS-Kippstufen, wobei das Produkt der Frequenzteilungsfaktoren dieser Teiler gleich *N* ist.

9. System zur Trägerrückgewinnung nach einem der Ansprüche 1 bis 6, **dadurch gekennzeichnet, dass** die Trägerregenerationsschaltung einen injektionsverriegelten Oszillator umfasst, der bei der Frequenz $Nf_c$ arbeitet, auf den ein Frequenzteiler mit Faktor *N* folgt, wobei sich der Oszillator auf der nicht-modulierten Komponente mit $Nf_c$ des vorkonditionierten Signals phasenverriegelt und ein rein sinusförmiges Signal mit der Frequenz $Nf_c$ bereitstellt, wobei der Frequenzteiler die Frequenz dieses rein sinusförmigen Signals durch einen Faktor *N* teilt, um den Träger zu regenerieren.

10. System zur Trägerrückgewinnung nach einem der Ansprüche 1 bis 6, **dadurch gekennzeichnet, dass** die Trägerregenerationsschaltung einen injektionsverriegelten Oszillator umfasst, der bei der Frequenz $\dfrac{N}{M}f_c$ arbeitet, wobei *M* ein ganzzahliger Teiler von *N* ist, auf den ein Frequenzteiler mit Faktor $\dfrac{N}{M}$ folgt, wobei sich der Oszillator auf der nicht-modulierten Komponente mit $Nf_c$ des vorkonditionierten Signals frequenz- und phasenverriegelt und ein rein sinusförmiges Signal mit der Frequenz $\dfrac{N}{M}f_c$ bereitstellt, wobei der Frequenzteiler die Frequenz dieses rein sinusförmigen Signals um einen Faktor $\dfrac{N}{M}$ teilt, um den Träger zu regenerieren.

11. System zur Trägerrückgewinnung nach Anspruch 10, **dadurch gekennzeichnet, dass** das phasenmodulierte Signal ein QPSK-Signal ist, wobei der injektionsverriegelte Oszillator (910) ein differentieller Oszillator mit gekreuztem Paar ist, umfassend eine Resonanzschaltung LC, deren Resonanzfrequenz nahe bei $2f_c$ ist, wobei die Injektion des vorkonditionierten Signals im gemeinsamen Modus realisiert wird, wobei der Frequenzteiler die Frequenz des differentiellen Signals am Ausgang des Oszillators um einen Faktor 2 teilt.

12. System zur Trägerrückgewinnung nach einem der Ansprüche 1 bis 6, **dadurch gekennzeichnet, dass** die Trägerregenerationsschaltung einen injektionsverriegelten Oszillator umfasst, der bei der Frequenz $f_c$ arbeitet, wobei sich der Oszillator auf der nicht-modulierten Komponente mit $Nf_c$ des vorkonditionierten Signals frequenz- und phasenverriegelt und ein sinusförmiges Signal mit der Frequenz $f_c$ bereitstellt, um den Träger zu regenerieren.

13. System zur Trägerrückgewinnung nach Anspruch 12, **dadurch gekennzeichnet, dass** die Frequenzregenerationsschaltung zwei differentielle Oszillatoren mit gekreuztem Paar in Quadratur (1011, 1012) umfasst, die Resonanzschaltungen LC verwenden, deren Resonanzfrequenz nahe bei $f_c$ ist, wobei die Oszillatoren in Quadratur sich im gemeinsamen Modus injektionsverriegeln, wobei die Injektion im gemeinsamen Modus durch die Vorkonditionierungsschaltung realisiert wird, umfassend einen Transistor ($T_0$), der derart polarisiert ist, dass sein Polarisationspunkt zu einem nichtlinearen Bereich seiner Drain-Source-Stromcharakteristik als Funktion seiner Gate-Source-Spannung gehört, wobei der Transistor an seinem Gate mittels eines Verbindungskondensators das phasenmodulierte Signal empfängt.

**Claims**

1. A carrier recovery system for a coherent receiver for receiving a phase-modulated signal, *S(t)*, by means of an *N*-PSK modulation of said carrier where *N* is an even number, **characterised in that** it comprises:

   a signal pre-conditioning circuit (180) to provide a pre-conditioned signal having an unmodulated component at a harmonic $Nf_c$ of the carrier frequency, $f_c$, said unmodulated component at $Nf_c$ being obtained by multiplying the phase modulated signal and $K = \frac{N}{2} - 1$ delayed versions of this signal by respective delays $k\frac{T_c}{N}$, with

$k$ = 1, ..., K, each delay being defined within an integer multiple $\frac{T_c}{2}$, where $T_c = 1/f_c$ the result of said multiplication being subjected to a quadratic function;
a carrier regeneration circuit (190) to generate a sinusoidal wave signal at the carrier frequency by phase locking to said harmonic.

2. The carrier recovery system according to claim 1, **characterised in that** the signal pre-conditioning circuit obtains

$$SP(t) = \left| \prod_{k=0}^{\frac{N}{2}-1} S\left(t + \frac{kT_c}{N}\right) \right|$$

the pre-conditioned signal by means of.

3. The carrier recovery system according to claim 2, **characterised in that** the signal pre-conditioning circuit comprises a plurality $K$ of stages, each stage (k) comprising a delay (420k) having the value $\frac{T_c}{N}$, and a mixer ($410_k$), the mixer of a current stage (k) multiplying the signal provided by the mixer ($410_{k-1}$) of the previous stage (k-1) with the output signal of the delay ($420_{k-1}$) of the previous stage, after delaying it by the delay ($420_{k-1}$) of the current stage (k), the first stage receiving said phase modulated signal, the output signal of the mixer of the last stage ($410_k$) being rectified by means of a rectifier (430) to provide the pre-conditioned signal (SP(t)).

4. The carrier recovery system according to claim 2, **characterised in that** the signal pre-conditioning circuit comprises a plurality $K$ of stages, each stage (k) comprising a delay (520k) having the value $\frac{T_c}{N} + \frac{T_c}{2}$, and a mixer ($510_k$), the mixer of a current stage (k) multiplying the signal provided by the mixer ($510_{k-1}$) of the previous stage (k-1) with the output signal of the delay ($520_{k-1}$) of the previous stage, after delaying it by the delay ($520_k$) of the current stage (k), the first stage receiving said phase modulated signal, the output signal of the mixer of the last stage ($510_k$) being provided to a frequency doubler circuit (530), followed by a pass-band filter only passing said harmonic $Nf_c$ to provide the pre-conditioned signal $SP(t)$.

5. The carrier recovery system according to claim 2, **characterised in that** each mixer of a current stage (k) comprises a first pair of transistors (351, 352) and a second pair of transistors (353, 354), the gates of the transistors of the first pair and gates of the transistors of the second pair differentially receiving the output signal of the mixer of the previous stage (k-1), the drains of the transistors of the first pair and drains of transistors of the second pair differentially receiving the output signal of the delay ($520_k$) of the current stage (k), the output signal of the current stage ($520_k$) being differentially provided by the signal on the first common terminal of the sources of the transistors of the first pair and the signal on the second common terminal of the sources of the transistors of the second pair.

6. The carrier recovery system according to claim 2, **characterised in that** each mixer of a current stage $k$ = 1,..., $K$ comprises a first oscillatory circuit between the first common terminal and the ground and a second oscillatory circuit between the second common terminal and the ground, the first oscillatory circuit and second oscillatory circuit only passing the harmonic at the frequency $kf_c$.

7. The carrier recovery system according to one of the previous claims, **characterised in that** the carrier regeneration circuit is a frequency divider with a factor N.

8. The carrier recovery system according to claim 7, **characterised in that** it comprises an injection locked frequency divider followed by at least one frequency divider using a current mode logic CML and/or at least one CMOS-flip-flop-based frequency divider, the product of the frequency division factors of these dividers being equal to $N$.

9. The carrier recovery system according to one of claims 1 to 6, **characterised in that** the carrier regeneration circuit comprises an injection locked oscillator operating at frequency $Nf_c$, followed by a frequency divider with a factor N, the oscillator phase-locking to said unmodulated component at $Nf_c$ of the preconditioned signal and providing a purely sinusoidal wave signal at the frequency $Nf_c$, the frequency divider dividing the frequency of this purely sinusoidal wave signal with a factor $N$ to regenerate the carrier.

10. The carrier recovery system according to one of claims 1 to 6, **characterised in that** the carrier regeneration circuit comprises an injection locked oscillator operating at the frequency $\dfrac{N}{M}f_c$, where $M$ is an integer divider of $N$, followed by a frequency divider of factor $\dfrac{N}{M}$, the oscillator frequency- and phase-locking to said unmodulated component at $Nf_c$ of the pre-conditioned signal and providing a purely sinusoidal wave signal at the frequency $\dfrac{N}{M}f_c$, the frequency divider dividing the $N$ frequency of this purely sinusoidal wave signal with a factor $\dfrac{N}{M}$ to regenerate the carrier.

11. The carrier recovery system according to claim 10, **characterised in that** the phase-modulated signal is a QPSK signal, the injection locked oscillator (910) being a differential crossed pair oscillator comprising a resonant circuit LC, the resonant frequency of which is close to $2f_c$, injecting the pre-conditioned signal being performed in common mode, the frequency divider divides the frequency of the differential signal output from the oscillator by a factor 2.

12. The carrier recovery system according to one of claims 1 to 6, **characterised in that** the carrier regeneration circuit comprises an injection locked oscillator operating at the frequency $f_c$, the oscillator frequency- and phase-locking to said unmodulated component at $Nf_c$ of the preconditioned signal and providing a sinusoidal wave signal at the frequency $f_c$ to regenerate the carrier.

13. The carrier recovery system according to claim 12, **characterised in that** the frequency regeneration circuit comprises two quadrature differential crossed pair oscillators (1011, 1012), using resonant circuits LC, the resonant frequency of which is close to $f_c$, the quadrature oscillators locking by common mode injection, said common mode injection being performed by the pre-conditioning circuit, comprising a biased transistor ($T_0$) so that its bias point belongs to a non-linear part of its drain-source current characteristic as a function of its gate source voltage, said transistor receiving on its gate, through a coupling capacitor, the phase modulated signal.

**Fig. 1**

**Fig. 2A**

$$S'(t) = S(t) \cdot S\left(t + \frac{1}{4f_c}\right)$$

**Fig. 2B**

**Fig. 3A**

**Fig. 3B**

$S(t)$

$410_1$

$420_1$    $\Delta\phi, 2\pi/N$

$S\left(t+^1/_{Nf_c}\right)$

$410_2$

$420_2$    $\Delta\phi, 2\pi/N$

$S\left(t+^2/_{Nf_c}\right)$

$410_3$

$420_3$    $\Delta\phi, 2\pi/N$

$S\left(t+^3/_{Nf_c}\right)$

$420_K$    $\Delta\phi, 2\pi/N$

$410_K$    $430$

$|x(t)|$    $SP(t)$

$S\left(t+\dfrac{K}{Nf_c}\right)$

**Fig. 4**

**Fig. 5**

SP(t) @ $Nf_c$

LO(t) @ $f_c$

/N

0°

90°

**Fig. 6A**

SP(t) @ $Nf_c$

ILO @ $Nf_c$

/N

LO(t) @ $f_c$

0°

90°

**Fig. 6B**

SP(t) @ $Nf_c$

ILO @ $Nf_c/M$

/(N/M)

LO(t) @ $f_c$

0°

90°

**Fig. 6C**

SP(t) @ $Nf_c$

ILO @ $f_c$

LO(t) @ $f_c$

0°

90°

**Fig. 6D**

**Fig. 7**

810  ILO @ 4f$_c$  820

SP(t) @ 4f$_c$  →  $\rightarrow$  /4  →0°
                                      →90°  LO(t) @ f$_c$

VDD

LC-tank

Out ←  → $\overline{Out}$

SP ▷  ⊣⊢  ⊣⊢  ◁ $\overline{SP}$

Vbias_INJ ▷

Vbias ▷ ─WV─

**Fig. 8A**

**Fig. 8B**

910

ILO @ 2f$_c$
(ILFD)

920

SP(t) @ 4f$_C$ →  SP$_{ILO}$(t) @ 2f$_C$ → /2 → 0°

→ 90°  LO(t) @ f$_C$

VDD

LC-tank

Out ←    → $\overline{Out}$

SP

Vbias

**Fig. 9A**

LO(f)

SP$_{ILO}$(f)

SP(f)

S(f)

Spectre

0

-5

-10

-15

-20

-25

-30

0.0   0.5   1.0   1.5   2.0   2.5   3.0   3.5   4.0   4.5

Frequence/Fc

**Fig. 9B**

**Fig. 10A**

**Fig. 10B**

**RÉFÉRENCES CITÉES DANS LA DESCRIPTION**

**Documents brevets cités dans la description**

- US 6891440 B

**Littérature non-brevet citée dans la description**

- **H.J. LEE et al.** High-speed and low-power OOK CMOS transmitter and receiver for wireless chip-to-chip communication. *Proc. of IMWS,* 2015
- **S.J. HUANG et al.** W-band BPSK and QPSK transceivers with Costas-loop carrier recovery in 65-nm CMOS technology. *IEEE Journal of Solid-State Circuits,* Décembre 2011, vol. 46 (12), 3033-3046
- **Z. HE et al.** A 12Gbps analog QPSK baseband receiver based on injection-locked VCO. *Proc. of 2015 IEEE MTT-S International Microwave Symposium,* 2015, 1-4
- Carrier-Tracking Loops Employing The Phase-Lock Principle. **M.K. SIMON ; W.C. LINDSEY.** Telecommunication Systems Engineering. Englewood Cliffs, Prentice-Hall Inc, 01 Janvier 1973, 26-84
- Systems Employing The Phase-Lock Or Entrainment Principle. **W.C. LINDSEY.** Synchronization Systems in Communication and Control. Englewood Cliffs, Prentice-Hall, 01 Janvier 1972, 65-129